(19) Europäisches Patentamt / European Patent Office / Office européen des brevets

(11) **EP 4 685 504 A1**

(12) **EUROPEAN PATENT APPLICATION**
published in accordance with Art. 153(4) EPC

(43) Date of publication:
28.01.2026 Bulletin 2026/05

(21) Application number: 24907636.5

(22) Date of filing: 25.06.2024

(51) International Patent Classification (IPC):
*G01R 31/367* (2019.01)    *G01R 31/36* (2020.01)
*G01R 31/385* (2019.01)    *G01R 19/165* (2006.01)
*H01M 10/052* (2010.01)

(52) Cooperative Patent Classification (CPC):
G01R 19/165; G01R 31/36; G01R 31/367;
G01R 31/385; H01M 10/052

(86) International application number:
PCT/KR2024/008786

(87) International publication number:
WO 2025/135346 (26.06.2025 Gazette 2025/26)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 18.12.2023 KR 20230184490

(71) Applicant: LG Energy Solution, Ltd.
Seoul 07335 (KR)

(72) Inventor: KIM, Jaegu
Daejeon 34122 (KR)

(74) Representative: Plasseraud IP
104 Rue de Richelieu
CS92104
75080 Paris Cedex 02 (FR)

(54) **BATTERY MANAGEMENT DEVICE AND BATTERY CONTROL METHOD**

(57) Disclosed is a battery control method comprising the steps of: acquiring at least one of a voltage value, a current value, and a temperature value of a battery cell from on e or more sensors; calculating the state of charge of the battery cell on the basis of at lea st one of the voltage value, the current value, and the temperature value; estimating a ne gative electrode voltage value on the basis of at least one of the state of charge, the volta ge value, the current value, and the temperature value of the battery cell; and determinin g a target output value of the battery cell on the basis of the estimated negative electrode voltage value and a reference output value of the battery cell.

FIG. 4

EP 4 685 504 A1

Processed by Luminess, 75001 PARIS (FR)

## Description

### Technical Field

The present disclosure relates to a battery control method and a battery management apparatus performing a same.

### Background Art

There has been a fire breaking out due to lithium precipitation (e.g., a dendrite) when a battery anode voltage reaches a predetermined range in use of lithium-ion battery. A technology of controlling battery output power for prevention thereof has mainly based on a method of determining an output command value so that a terminal voltage value of a battery is positioned in a range between an overvoltage reference value and a low voltage reference value based on a current state of X (Sox) of the battery, an electric current of the battery, a temperature of the battery, and a voltage of the battery. In addition, research on a battery control method flexibly applicable in not only a situation of charging the battery in a plug-in state but also various operation situations is currently conducted.

### Detailed Description of the Invention

### Technical Goals

An example embodiment of the present disclosure is to prevent a lithium precipitation phenomenon by estimating an anode voltage in addition to a terminal voltage of a battery cell through parameters associated with an anode voltage estimation model.

An example embodiment of the present disclosure is to set an appropriate output value of charging power through continuous monitoring of an anode voltage value, prevent a lithium precipitation phenomenon, and flexibly manage the charging power.

### Technical solutions

According to an example embodiment, there is provided a battery control method performed by a battery management apparatus, the battery control method including acquiring at least one of a voltage value, an electric current value, or a temperature value of a battery cell from one or more sensors, calculating a state of charge of the battery cell based on the at least one of the voltage value, the electric current value, or the temperature value, estimating an anode voltage value based on at least one of the state of charge, the voltage value, the electric current value, or the temperature value of the battery cell, and determining a target output value of the battery cell based on the estimated anode voltage value and a reference output value of the battery cell.

The determining may include determining the target output value to be decreased by a first control unit value when the anode voltage value is less than a first reference value.

The first control unit value may be determined to be larger as a difference between the anode voltage value and the first reference value is larger.

At least one of the first reference value or the first control unit value may be determined based on a user input.

The determining may include determining the target output value to be increased by a second control unit value when the anode voltage value exceeds a second reference value.

The second control unit value may be determined to be larger as a difference between the anode voltage value and the second reference value is larger.

At least one of the second reference value or the second control unit value may be determined based on a user input.

The battery control method may further include determining the target output value to be a value equal to the reference output value when the target output value exceeds the reference output value.

The reference output value may be acquired based on the voltage value, the electric current value, and the temperature value, and the state of charge of the battery cell.

According to an example embodiment, there is also provided a battery management apparatus configured to perform a battery control method, the battery management apparatus including one or more sensors configured to acquire at least one of a voltage value, an electric current value, or a temperature value of a battery cell, a memory configured to store an instruction, and a processor connected to the memory, and the processor may be configured to acquire at least one of the voltage value, the electric current value, or the temperature value of the battery cell from the one or more sensors, calculate a state of charge of the battery cell based on the at least one of the voltage value, the electric current value, or the temperature value, estimate an anode voltage value based on at least one of the state of charge, the voltage value, the electric current value, or the temperature value of the battery cell, and determine a target output value of the battery cell based on the estimated anode voltage value and a reference output value of the battery cell.

Additional aspects of example embodiments will be set forth in part in the following description and drawings.

### Effects of the Invention

According to an example embodiment, it is possible to prevent a lithium precipitation phenomenon by estimating an anode voltage in addition to a terminal voltage of a battery cell through parameters associated with an anode voltage estimation model.

According to an example embodiment, it is possible to set an appropriate output value of charging power through continuous monitoring of an anode voltage value, prevent the lithium precipitation phenomenon, and flexibly manage the charging power.

**Brief Description of Drawings**

FIG. 1 is a diagram for describing a configuration of a system that performs a battery control method according to an example embodiment.

FIGS. 2A and 2B are diagrams for describing overall concepts of a battery control method according to an example embodiment.

FIG. 3 is a diagram for describing a process of estimating an anode voltage value in a battery control method according to an example embodiment.

FIG. 4 is a flowchart for describing a battery control method according to an example embodiment.

FIG. 5 is a diagram for describing an output control method according to a range of an anode voltage value in a battery control method according to an example embodiment.

FIG. 6 is a flowchart for describing a battery output control operation in a battery control method according to an example embodiment.

FIG. 7 is a block diagram illustrating a battery management apparatus according to an example embodiment.

**Mode for Carrying Out the Invention**

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. In this case, the meanings of these terms may be described in corresponding description parts of the disclosure. Accordingly, it should be noted that the terms used herein should be construed based on practical meanings thereof and the whole content of this specification, rather than being simply construed based on names of the terms.

In the entire specification, when an element is referred to as "including" another element, the element should not be understood as excluding other elements so long as there is no special conflicting description, and the element may include at least one other element.

Throughout the specification, expression "at least one of a, b, and c" may include 'a only', 'b only', 'c only', 'a and b', 'a and c', 'b and c', or 'all of a, b, and c'.

In the present disclosure, an "apparatus" may be implemented as a computer or a portable apparatus capable of accessing a server or another apparatus through a network. Here, the computer may include, for example, a laptop computer, a desktop computer, and a notebook equipped with a web browser. The portable apparatus may be a wireless communication device ensuring a portability and a mobility, and include any type of handheld wireless communication device, for example, a tablet PC, a smartphone, a communication-based apparatus such as international mobile telecommunication (IMT), code division multiple access (CDMA), W-code division multiple access (W-CDMA), and long term evolution (LTE).

In the following description, example embodiments of the present disclosure will be described in detail with reference to the accompanying drawings so that those skilled in the art can easily carry out the present disclosure. The present disclosure may be embodied in many different forms and is not limited to the example embodiments described herein.

Hereinafter, the example embodiments of the present disclosure will be described with reference to the drawings.

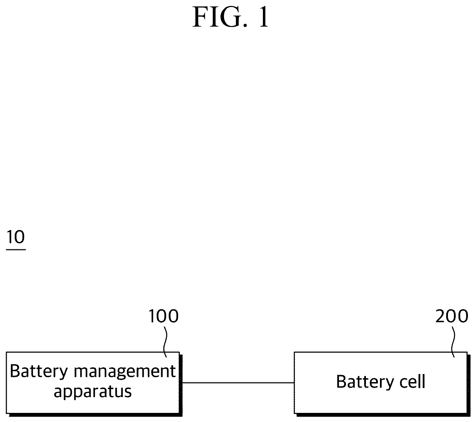

FIG. 1 is a diagram for describing a configuration of a system that performs a battery control method according to an example embodiment.

A dendrite phenomenon in which a lithium crystal is precipitated on an anode surface in a process of charging the battery may occur at a time of operating a lithium-ion battery. The dendrite phenomenon is a main factor of decreasing a life and stability of the lithium-ion battery. Particularly, when a dendrite starts to form on a surface of an electrode in the battery, a lithium ion moving between a cathode and an anode may not smoothly move, energy efficiency of the battery may be decreased, and the life of the battery may be decreased. In addition, when a size of the dendrite is increased as the dendrite grows, a separation film for blocking the cathode and the anode of the battery so that each does not meet another may be damaged. When the separation film is damaged, as the cathode and the anode are in direct contact, a short circuit in the battery may occur, which may be a cause of a fire. Accordingly, a variety of research for preventing occurrence of the dendrite phenomenon by appropriately managing a voltage of the battery is currently conducted.

Referring to FIG. 1, a system 10 that performs the battery control method may operate by interlocking with a battery management apparatus 100 that manages a battery cell 200. At this point, the battery cell 200 may correspond to a battery cell to be controlled by the battery management apparatus 100 in order to prevent a lithium precipitation phenomenon. Meanwhile, only elements associated with the present example embodiment are illustrated in FIG. 1. Thus, those skilled in the art which is associated with the present example embodiment may understand that other elements in general use may be further included in addition to the elements illustrated in FIG. 1.

The battery management apparatus 100 may include each of one or more sensors for measuring a parameter such as an electric current, a voltage, and a temperature of the battery cell 200 described above and include a memory and a processor (not illustrated) for various operations. In other words, the battery management apparatus 100 may operate based on the memory and the processor, but may further include a sensor and measure and calculate the parameter of the battery cell 200. According to an example embodiment, the battery management apparatus 100 may measure the parameter of the battery cell 200 by applying an external alternating current power source, namely, an alternating current voltage or an alternating current to the battery cell 200 in various frequencies and measuring an electric current flowing or voltage according thereto.

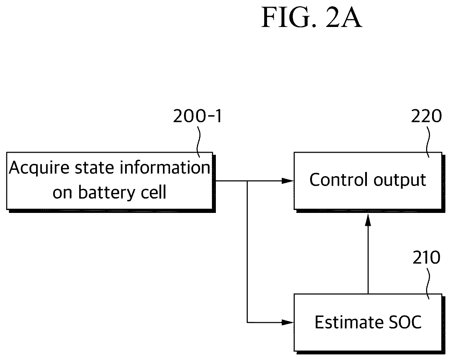

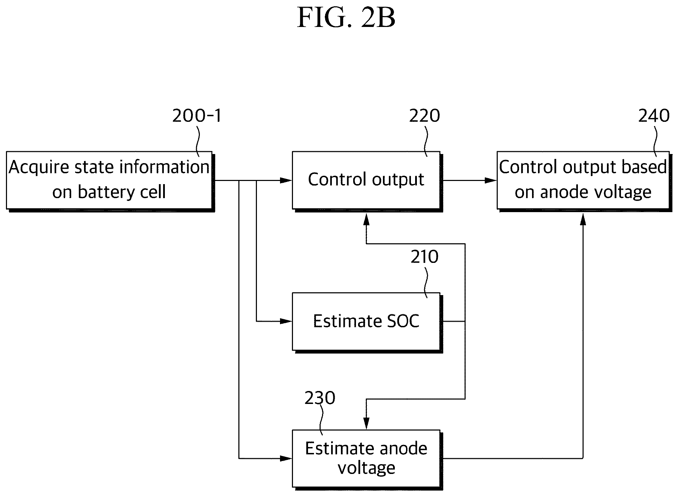

FIGS. 2A and 2B are diagrams for comparing overall concepts of a battery control method according to an example embodiment.

Referring to FIG. 2A, a battery control method in the related art may be identified. The battery control method in the related art has been mainly based on a scheme of performing acquisition 200-1 of state information on a battery cell by measuring a voltage, an electric current, and a temperature from the battery cell, performing estimation 210 of a state of charge (SoC) of the battery cell based thereon, and then performing charge output control 220 for controlling a terminal voltage that is a sum of a cathode voltage and an anode voltage of the battery cell in order to prevent a lithium precipitation phenomenon based on the voltage, the electric current, the temperature, and the SoC of the battery cell.

In this case, lithium precipitation may have been prevented by using a charge map on data acquired at a time of plug-in charging of the battery cell through maintaining the terminal voltage of the cell to be in a range not exceeding an overvoltage reference (e.g., approximately 4.2 volts (V)) and not less than a low voltage reference (e.g., approximately 2.5 V) through terminal voltage-based output control 220. However, the lithium precipitation may occur not only in the plug-in charging of the battery cell but also in regenerative charging of the battery cell during traveling, and an additional measure for preventing the lithium precipitation has not been clear in a situation corresponding thereto.

Referring to FIG. 2B, the battery control method according to an example embodiment may be identified.

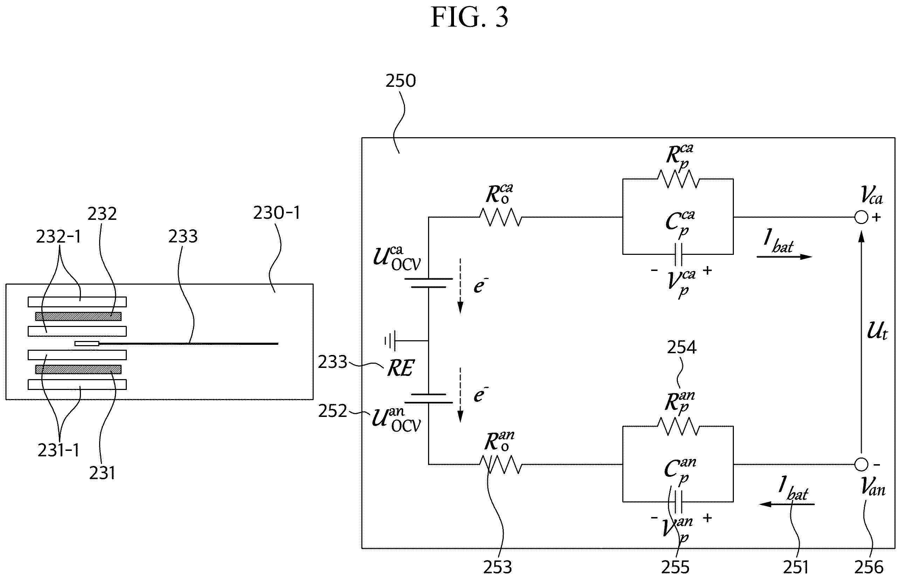

The battery management apparatus 100 according to an example embodiment may additionally perform anode voltage estimation 230 based on at least one of a state of charge, a voltage value, an electric current value, or a temperature value of the battery cell 200 in addition to the scheme, which is described above in FIG. 2A, of performing the acquisition 200-1 of the state information on the battery cell by measuring the voltage, the electric current, and the temperature from the battery cell, performing the estimation 210 of the state of charge, and performing the charge output control 220 for controlling the terminal voltage. Since an anode voltage may not directly measured in an ordinary battery cell, the battery management apparatus 100, for example, may estimate the anode voltage by using an anode model of the battery cell, which is appropriately modeled. A detailed process of the battery management apparatus 100 performing the anode voltage estimation 230 will be described below with reference to FIG. 3.

Furthermore, the battery management apparatus 100 may additionally perform anode voltage-based output control 240 of determining a target output value of the battery cell 200 based on a reference output value having a terminal voltage acquired through the output control 220 as a reference and an anode voltage value estimated through the anode voltage estimation 230. In other words, the battery management apparatus 100 may serially perform the anode voltage-based output control 240 after the output control 220 of performing terminal voltage control. Through this, the battery management apparatus 100 may appropriately control an anode voltage so that the estimated anode voltage value does not enter into, for example, a range less than or equal to 0 V. The battery management apparatus 100 according to an example embodiment may prevent the lithium precipitation, which may occur in regenerative charging of the battery cell, through the anode voltage estimation 230 and the anode voltage-based output control 240 which are described below in detail.

FIG. 3 is a diagram for describing a process of estimating an anode voltage value in a battery control method according to an example embodiment.

Referring to FIG. 3, a structure of an anode model 230-1 usable by a battery management apparatus according to an example for estimating the anode voltage value may be identified. The anode model 230-1 may include, for example, an anode 231, an anode separation film 231-1 surrounding the anode 231, a cathode 232, a cathode separation film 232-1 surrounding the cathode 232, and a reference electrode 233 positioned between the anode separation film 231-1 and the cathode separation film 232-1 as illustrated in FIG. 3.

The battery management apparatus 100 may estimate the anode voltage value based on at least one of a state of charge, a voltage value, an electric current value, or a temperature of a battery cell. For example, in order to estimate an anode voltage value 256 from the anode model 230-1, the battery management apparatus 100 may use a modeled circuit 250 as illustrated in FIG. 3, may acquire a plurality of parameters through voltage response data that is output when various electric current pulses are input to the circuit, and may estimate the anode voltage value based thereon. For example, after acquiring an open circuit voltage 252 after application of an electric current 251, the battery management apparatus 100 may acquire the plurality of parameters which includes anode ohmic resistance $R_o^{an}$ of reference numeral 253, anode internal resistance $R_p^{an}$ of reference numeral 254, and anode internal capacitance of reference numeral 255. In this case, for example, the anode internal resistance $R_p^{an}$ of reference numeral 254 may be acquired in consideration of the state of charge of the battery cell, and the battery management apparatus 100 may estimate the anode voltage value 256 based on the parameters. In this case, the anode voltage value 256 may be a voltage of an anode terminal, which is measured with the reference electrode 233 as a ground reference. The modeled circuit 250 may be, for example, in consideration of being lighter, an electric circuit model-based circuit in which calculation is light, but example embodiments according to the present disclosure are not limited to the above-described case. For example, the battery management apparatus 100 may acquire an anode terminal voltage so that a terminal voltage error acquired through an actual anode cell voltage and an anode ECM-based circuit is greatly small (for example, in a margin of error of approximately a root mean square error (RMSE) of 10 to 17 millivolts (mV), and a maximum error is within a range from 27 mV to 42 mV).

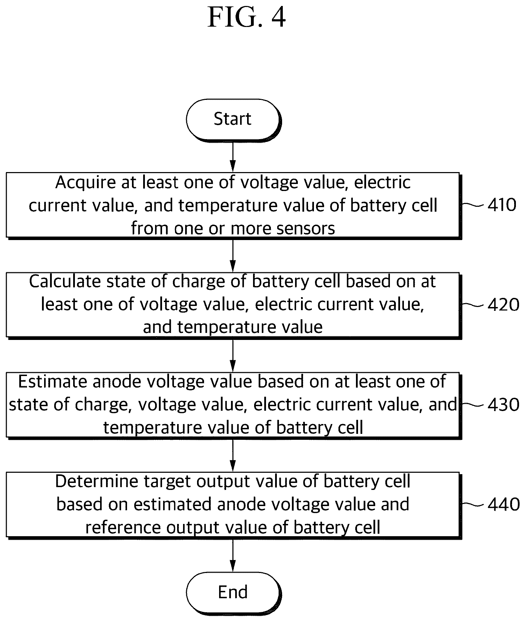

FIG. 4 is a flowchart for describing a battery control method according to an example embodiment.

Referring to FIG. 4, in operation 410, the battery management apparatus 100 according to an example embodiment may acquire at least one of a voltage value, an electric current value, or a temperature value of a battery cell from one or more sensors. The voltage value of the battery cell may be detected through a voltage sensor, converted into an electric signal, and acquired. The electric current value of the battery cell may be acquired by detecting, through an electric current sensor, a change in a magnetic field that occurs while an electric current flows. The temperature value of the battery cell may be acquired by a temperature sensor that is attached to a surface or an inside of a battery to measure a temperature of the battery.

In operation 420, the battery management apparatus 100 according to an example embodiment may calculate a state of charge of the battery cell based on the at least one of the voltage value, the electric current value, or the temperature value. An SoC, which is the state of charge of the battery cell, may be calculated with a predefined voltage value and a state of charge characteristic. The SoC may be calculated in consideration of an amount of charging or discharging over time through electric current integration.

In operation 430, the battery management apparatus 100 according to an example embodiment may estimate an anode voltage value based on the at least one of the state of charge, the voltage value, the electric current value, or the temperature value of the battery cell. The battery management apparatus 100 may estimate the anode voltage value through the anode model and the ECM-based circuit described above in FIG. 3.

In operation 440, the battery management apparatus 100 according to an example embodiment may determine a target output value of the battery cell based on the estimated anode voltage value and a reference output value of the battery cell. The battery management apparatus 100 may flexibly change the target output value of the battery cell in consideration of the reference output value so that the anode voltage value does not enter into a range having a possibility of lithium precipitation.

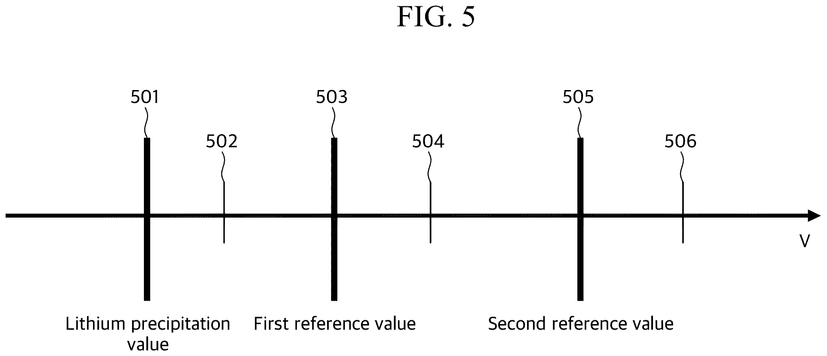

FIG. 5 is a diagram for describing an output control method according to a range of an anode voltage value in a battery control method according to an example embodiment.

A battery management apparatus according to an example embodiment may identify an anode voltage state of a battery based on an anode voltage value of the battery, a lithium precipitation value 501, a first reference value 503 for determining a danger of lithium precipitation to be present due to a decrease in the anode voltage value of the battery, and a second reference value 505 that is a reference for determining the anode voltage value of the battery to be safe from the danger of the lithium precipitation or an overcharge reference and may perform appropriate battery output control. Here, the first reference value 503 may be larger than the lithium precipitation value 501, the second reference value 505 may be larger than the first reference value 503, and all of the first reference value 503 and the second reference value 505 may be flexibly determined by a user input.

Here, the lithium precipitation value 501 may vary depending on an operation situation of the battery, but may be generally an anode electric potential value at which the lithium precipitation occurs to start a dendrite phenomenon, and may correspond to, for example, approximately 0 V.

Here, the first reference value 503 may correspond to a reference value for determining that control to change the anode voltage value of the battery to a higher value is required because the anode voltage value of the battery is close to the lithium precipitation value 501 in operation of the battery and may be set to, for example, approximately 0.1 V. For example, the battery management apparatus 100 may perform control to change the target output value when the anode voltage value is less than the first reference value 503 and exceeds the lithium precipitation value 501 as shown by a first anode voltage value 502, to change a target output value so that the first anode voltage value 502 has a second anode voltage value 504 positioned in a range that exceeds the first reference value 503 and is less than the second reference value 505.

Here, the second reference value 505 may correspond to a reference value for determining that an output to be controlled is allowed to be increased because the anode voltage value is sufficiently far from the lithium precipitation value 501 in the operation of the battery and may be set to, for example, approximately 0.2 V. For example, when the anode voltage value exceeds the second reference value 505 as shown by a third anode voltage value 506, since the battery management apparatus 100 may determine that the anode voltage value is sufficiently larger than the lithium precipitation value 501 even if a charging output used in charging is increased so that the anode voltage value is slightly decreased, the battery management apparatus 100 may perform control to change the target output value

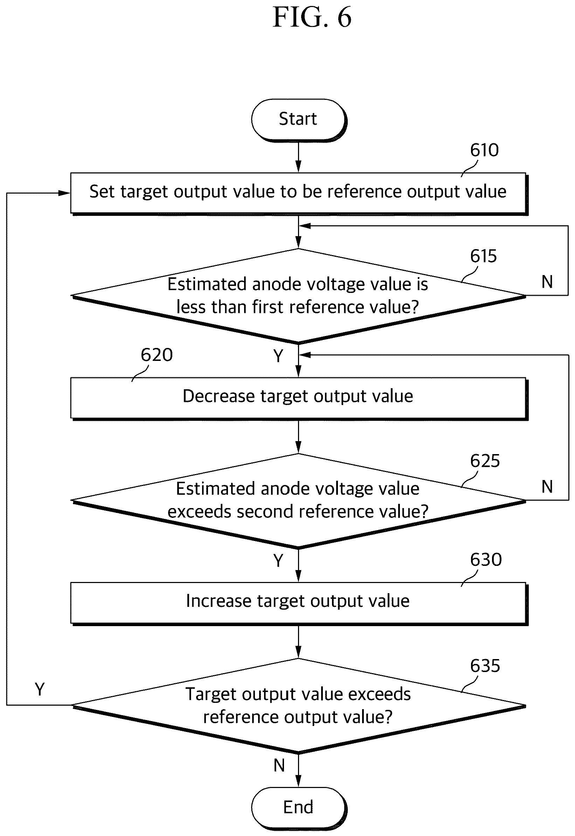

FIG. 6 is a flowchart for describing a battery output control operation in a battery control method according to an example embodiment.

Referring to FIG. 6, in operation 610, the battery management apparatus 100 according to an example embodiment may determine a target output value to be a reference output value. For example, the battery management apparatus 100 may determine the target output value based on an anode voltage value estimated from an anode model based on at least one of a state of charge, a voltage value, an electric current value, or a temperature value of a battery cell and the reference output value which is acquired based on the voltage value, the electric current value, and the temperature value of the battery cell and may determine the target output value to be the reference output value in operation 610 of the battery control method. The battery management apparatus 100 may perform control so that an estimated anode value is not decreased to be less than or equal to a lithium precipitation value in overall performance of the battery control method.

In operation 615, the battery management apparatus 100 according to an example embodiment may determine whether the estimated anode voltage value is less than a first reference value. When the estimated anode voltage value is determined as being less than the first reference value in operation 615, the battery management apparatus 100 may allow the estimated anode voltage value to be larger than the first reference value by decreasing the target output value by a first control unit value in operation 620. In this case, the first control unit value may be determined to be larger as a difference between the anode voltage value and the first reference value is larger. When a degree of concern for lithium precipitation is determined as being high because the anode voltage value is largely different from the first reference value, the battery management apparatus 100 may determine the first control unit value to be large in order to rapidly decrease the target output value. For example, at least one of the first reference value or the first control unit value may be determined based on a user input, and the battery management apparatus 100 may perform flexible battery control to correspond to various operation situations. When the estimated anode voltage value is determined as not being less than the first reference value in operation 615, the battery management apparatus 100 may repeatedly perform monitoring of the estimated voltage value without changing the target output value.

In operation 625, the battery management apparatus 100 according to an example embodiment may determine whether the estimated anode voltage value exceeds a second reference value. For example, when the estimated anode voltage value exceeds the second reference value, the battery management apparatus 100 may allow the estimated anode voltage value to be smaller than the second reference value by increasing the target output value by a second control unit value in operation 630. In this case, the second control unit value may be determined to be larger as a difference between the anode voltage value and the second reference value is larger. When the degree of the concern for the lithium precipitation is determined as being greatly low because the anode voltage value is largely different from the second reference value, and when the degree of the concern for the lithium precipitation is determined as not being high even if a charge output to be used in charging the battery cell is sufficiently increased, the battery management apparatus 100 may determine the second control unit value to be large in order to further increase the target output value by an enough amount. For example, at least one of the second reference value or the second control unit value may be determined based on a user input, and the battery management apparatus 100 may perform the flexible battery control to correspond to the various operation situations. When the estimated anode voltage value is determined as not exceeding the second reference value in operation 625, the battery management apparatus 100 may repeatedly perform the monitoring of the estimated voltage value without changing the target output value which is decreased.

In operation 635, the battery management apparatus 100 according to an example embodiment may determine whether the target output value exceeds the reference output value. When the target output value is determined as exceeding the reference output value in operation 635 after the target output value is increased in operation 630, the battery management apparatus 100 may return back to operation 610, determine the target output value to be the reference output value, and repeat the above-described operations. That is, the battery management apparatus 100 may monitor the anode voltage value according to the voltage value, the electric current value, the temperature value, and a state of charge value of the battery cell, acquire the reference output value, and then flexibly change the target output value in consideration of appropriate balance with regenerative charging while avoiding a danger of the lithium precipitation through continuous monitoring of the anode voltage value.

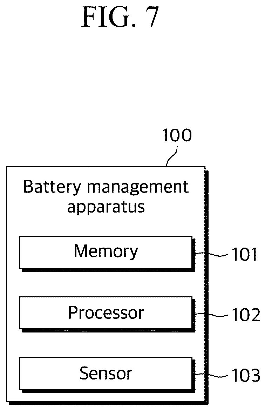

FIG. 7 is a block diagram illustrating a battery management apparatus according to an example embodiment.

The battery management apparatus 100 may include one or more sensors 103 that acquire at least one of a voltage value, an electric current value, or a temperature value of a battery cell, a memory 101, and a processor 102. Only elements associated with the present example embodiment are illustrated in the battery management apparatus 100 which is illustrated in FIG. 6. Thus, those skilled in the art which is associated with the present example embodiment may understand that other elements in general use may be further included in addition to the elements illustrated in FIG. 6. In an example embodiment, the processor 102 may be included in a controller.

The processor 102 may control overall operations of the battery management apparatus 100 and process data and a signal. The processor 102 may include at least one hardware unit. Also, the processor 102 may be operated by one or more software modules generated by executing program code stored in the memory 101. Since the processor 102 may include a memory, the processor 102 may control the overall operations of the battery management apparatus 100 and process the data and the signal by executing program code stored in a memory.

The processor 102 may be set to acquire at least one of the voltage value, the electric current value, or the temperature value of the battery cell from the one or more sensors 103, calculate a state of charge of the battery cell based on the at least one of the voltage value, the electric current value, or the temperature value, estimate an anode voltage value based on at least one of the state of charge, the voltage value, the electric current value, or the temperature value of the battery cell, and determine a target output value of the battery cell based on the estimated anode voltage value and a reference output value of the battery cell.

For example, the processor 102 may be set to determine the target output value to be decreased by a first control unit value when the anode voltage value is less than a first reference value.

For example, the processor 102 may be set to determine the target output value to be increased by a second control unit value when the anode voltage value exceeds a second reference value.

For example, the processor 102 may be set to determine the target output value to be a value equal to the reference output value when the target output value exceeds the reference output value due to a change in the target output value.

The sensors 103 may include a plurality of sensors and acquire the at least one of the voltage value, the electric current value, or the temperature value of the battery cell.

Depending on example embodiments, the battery management apparatus 100 may additionally include a transceiver for performing wired/wireless communication. The battery management apparatus 100 may communicate with an external electronic apparatus by using the transceiver. The electronic apparatus may be a terminal or a server. Also, a communication technology used by the transceiver may include Global System for Mobile communication (GSM), Code Division Multi Access (CDMA), Long Term Evolution (LTE), 5th Generation, (5G), a wireless local area network (WLAN), Wireless-Fidelity (Wi-Fi), Bluetooth, radio frequency identification (RFID), infrared data association (IrDA), ZigBee, near field communication (NFC), or the like.

The apparatus according to the above-described example embodiments may include a processor, a memory that stores and executes program data, a permanent storage such as a disk drive, a communication port for communicating with an external device, and a user interface device such as a touch panel, a key, and an icon. Methods implemented by software modules or algorithms may be stored in a computer-readable recording medium as computer-readable code or program instructions executable in the processor. Here, the computer-readable recording medium may include a magnetic storage medium (e.g., a read-only memory (ROM), a random-access memory (RAM), a floppy disk, a hard disk, or the like), an optical reading medium (e.g., a CD-ROM or a digital versatile disc (DVD)), or the like. The computer-readable recording medium may be dispersed to computer systems connected by a network so that computer-readable codes may be stored and executed in a dispersed manner. The medium may be read by a computer, stored in the memory, and executed by the processor.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, and assembler language including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor, for example.

The above-described embodiments are merely examples and other embodiments may be implemented within the scope of the following claims.

**Claims**

1. A battery control method performed by a battery management apparatus, the battery control method comprising:

    acquiring at least one of a voltage value, an electric current value, or a temperature value of a battery cell from one or more sensors;
    calculating a state of charge of the battery cell based on the at least one of the voltage value, the electric current value, or the temperature value;
    estimating an anode voltage value based on at least one of the state of charge, the voltage value, the electric current value, or the temperature value of the battery cell; and
    determining a target output value of the battery cell based on the estimated anode voltage value and a reference output value of the battery cell.

2. The battery control method of claim 1, wherein the determining comprises determining the target output value to be decreased by a first control unit value when the anode voltage value is less than a first reference value.

3. The battery control method of claim 2, wherein the first control unit value is determined to be larger as a difference between the anode voltage value and the first reference value is larger.

4. The battery control method of claim 2, wherein at least one of the first reference value or the first control unit value is determined based on a user input.

5. The battery control method of claim 1, wherein the determining comprises determining the target output value to be increased by a second control unit value when the anode voltage value exceeds a second reference value.

6. The battery control method of claim 5, wherein the second control unit value is determined to be larger as a difference between the anode voltage value and the second reference value is larger.

7. The battery control method of claim 5, wherein at least one of the second reference value or the second control unit value is determined based on a user input.

8. The battery control method of claim 5, further comprising determining the target output value to be a value equal to the reference output value when the target output value exceeds the reference output value.

9. The battery control method of claim 1, wherein the reference output value is acquired based on the voltage value, the electric current value, and the temperature value, and the state of charge of the battery cell.

10. A non-transitory computer-readable recording medium in which a program for executing the method of any one of claims 1 through 9 in a server is recorded.

11. A battery management apparatus configured to perform a battery control

    method, the battery management apparatus comprising:

        one or more sensors configured to acquire at least one of a voltage value,
        an electric current value, or a temperature value of a battery cell;
        a memory configured to store an instruction; and
        a processor connected to the memory, wherein the processor is configured to:

    acquire at least one of the voltage value, the electric current value, or the temperature value of the battery cell from the one or more sensors;
    calculate a state of charge of the battery cell based on the at least one of the voltage value, the electric current value, and the temperature value; estimate an anode voltage value based on at least one of the state of charge, the voltage value, the electric current value, or the temperature value of the battery cell; and
    determine a target output value of the battery cell based on the estimated anode voltage value and a reference output value of the battery cell.

# FIG. 1

10

| Battery management apparatus | | Battery cell |
|---|---|---|
| 100 | | 200 |

# FIG. 2A

200-1

Acquire state information
on battery cell

220

Control output

210

Estimate SOC

# FIG. 2B

200-1

Acquire state information
on battery cell

220

Control output

240

Control output based
on anode voltage

210

Estimate SOC

230

Estimate anode
voltage

FIG. 3

# FIG. 4

```
                        ┌─────────┐
                        │  Start  │
                        └─────────┘
                             │
                             ▼
┌──────────────────────────────────────────────────┐
│      Acquire at least one of voltage value,       │
│ current value, and temperature value of battery   │── 410
│    cell from one or more sensors                  │
└──────────────────────────────────────────────────┘
                             │
                             ▼
┌──────────────────────────────────────────────────┐
│  Calculate state of charge of battery cell based  │
│   on at least one of voltage value, electric      │── 420
│       current value, and temperature value        │
└──────────────────────────────────────────────────┘
                             │
                             ▼
┌──────────────────────────────────────────────────┐
│  Estimate anode voltage value based on at least   │
│ one of state of charge, voltage value, electric   │── 430
│  current value, and temperature value of battery  │
│                     cell                          │
└──────────────────────────────────────────────────┘
                             │
                             ▼
┌──────────────────────────────────────────────────┐
│     Determine target output value of battery      │
│  cell based on estimated anode voltage value and  │── 440
│       reference output value of battery cell      │
└──────────────────────────────────────────────────┘
                             │
                             ▼
                        ┌─────────┐
                        │   End   │
                        └─────────┘
```

FIG. 5

501 503 505

502 504 506

V

Lithium precipitation value    First reference value    Second reference value

EP 4 685 504 A1

# FIG. 6

Start

610
Set target output value to be reference output value

615
Estimated anode voltage value is less than first reference value? — N

Y

620
Decrease target output value

625
Estimated anode voltage value exceeds second reference value? — N

Y

630
Increase target output value

635
Target output value exceeds reference output value? — Y

N

End

# FIG. 7

100

**Battery management apparatus**

| Memory | ~101 |
| Processor | ~102 |
| Sensor | ~103 |

## INTERNATIONAL SEARCH REPORT

| | International application No. |
|---|---|
| | **PCT/KR2024/008786** |

| **A.** | **CLASSIFICATION OF SUBJECT MATTER** |
|---|---|
| | **G01R 31/367**(2019.01)i; **G01R 31/36**(2006.01)i; **G01R 31/385**(2019.01)i; **G01R 19/165**(2006.01)i; **H01M 10/052**(2010.01)i |

According to International Patent Classification (IPC) or to both national classification and IPC

| **B.** | **FIELDS SEARCHED** |
|---|---|

Minimum documentation searched (classification system followed by classification symbols)

G01R 31/367(2019.01); G01R 19/00(2006.01); G01R 31/36(2006.01); G01R 31/374(2019.01); G01R 31/385(2019.01); G01R 31/389(2019.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 관리 장치(battery management unit), 배터리 셀(battery cell), 전압(voltage), 전류(current), 온도(temperature), 충전(charge), 음극(cathode)

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| A | KR 10-2017-0116816 A (SAMSUNG SDI CO., LTD.) 20 October 2017 (2017-10-20)<br>See paragraph [0071]; and claims 13-14. | 1-11 |
| A | KR 10-2020-0141091 A (CONTEMPORARY AMPEREX TECHNOLOGY CO., LIMITED) 17 December 2020 (2020-12-17)<br>See claims 1-3; and figure 1. | 1-11 |
| A | KR 10-2021-0039186 A (LG CHEM, LTD.) 09 April 2021 (2021-04-09)<br>See paragraphs [0034]-[0099]; and figures 2-4. | 1-11 |
| A | KR 10-2022-0100471 A (LG ENERGY SOLUTION, LTD.) 15 July 2022 (2022-07-15)<br>See claims 1-2; and figure 3. | 1-11 |
| A | EP 4227696 A1 (JIANGSU CONTEMPORARY AMPEREX TECHNOLOGY LIMITED) 16 August 2023 (2023-08-16)<br>See claim 1; and figures 2-3. | 1-11 |

☐ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **07 October 2024** | **08 October 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

| International application No. |
| --- |
| **PCT/KR2024/008786** |

| Patent document cited in search report | | | Publication date (day/month/year) | Patent family member(s) | | | Publication date (day/month/year) |
| --- | --- | --- | --- | --- | --- | --- | --- |
| KR | 10-2017-0116816 | A | 20 October 2017 | CN | 108886262 | A | 23 November 2018 |
| | | | | CN | 108886262 | B | 07 July 2023 |
| | | | | CN | 113364090 | A | 07 September 2021 |
| | | | | CN | 113364090 | B | 28 May 2024 |
| | | | | EP | 3444917 | A1 | 20 February 2019 |
| | | | | EP | 3444917 | B1 | 20 July 2022 |
| | | | | HU | E059851 | T2 | 28 January 2023 |
| | | | | KR | 10-2589963 | B1 | 13 October 2023 |
| | | | | PL | 3444917 | T3 | 14 November 2022 |
| | | | | US | 11309728 | B2 | 19 April 2022 |
| | | | | US | 12015297 | B2 | 18 June 2024 |
| | | | | US | 2020-0328608 | A1 | 15 October 2020 |
| | | | | US | 2022-0200305 | A1 | 23 June 2022 |
| | | | | WO | 2017-179827 | A1 | 19 October 2017 |
| KR | 10-2020-0141091 | A | 17 December 2020 | CN | 110967645 | A | 07 April 2020 |
| | | | | CN | 110967645 | B | 07 May 2021 |
| | | | | CN | 113075555 | A | 06 July 2021 |
| | | | | EP | 3745151 | A1 | 02 December 2020 |
| | | | | EP | 3745151 | B1 | 26 January 2022 |
| | | | | JP | 2020-193963 | A | 03 December 2020 |
| | | | | JP | 6963647 | B2 | 10 November 2021 |
| | | | | KR | 10-2301406 | B1 | 13 September 2021 |
| | | | | US | 10871521 | B2 | 22 December 2020 |
| | | | | US | 11366170 | B2 | 21 June 2022 |
| | | | | US | 2020-0371162 | A1 | 26 November 2020 |
| | | | | US | 2021-0041503 | A1 | 11 February 2021 |
| | | | | WO | 2020-238583 | A1 | 03 December 2020 |
| KR | 10-2021-0039186 | A | 09 April 2021 | CN | 114127571 | A | 01 March 2022 |
| | | | | EP | 3992650 | A1 | 04 May 2022 |
| | | | | EP | 3992650 | B1 | 31 July 2024 |
| | | | | JP | 2022-540401 | A | 15 September 2022 |
| | | | | JP | 7359350 | B2 | 11 October 2023 |
| | | | | US | 11828806 | B2 | 28 November 2023 |
| | | | | US | 2022-0283232 | A1 | 08 September 2022 |
| | | | | WO | 2021-066396 | A1 | 08 April 2021 |
| KR | 10-2022-0100471 | A | 15 July 2022 | CN | 116724244 | A | 08 September 2023 |
| | | | | EP | 4276483 | A1 | 15 November 2023 |
| | | | | JP | 2024-501304 | A | 11 January 2024 |
| | | | | US | 2024-0003980 | A1 | 04 January 2024 |
| | | | | WO | 2022-149917 | A1 | 14 July 2022 |
| EP | 4227696 | A1 | 16 August 2023 | CN | 113341208 | A | 03 September 2021 |
| | | | | CN | 113341208 | B | 15 October 2021 |
| | | | | JP | 2024-501682 | A | 15 January 2024 |
| | | | | JP | 7408021 | B1 | 04 January 2024 |
| | | | | KR | 10-2023-0096130 | A | 29 June 2023 |
| | | | | KR | 10-2616480 | B1 | 21 December 2023 |
| | | | | US | 11894527 | B2 | 06 February 2024 |
| | | | | US | 2023-0411711 | A1 | 21 December 2023 |
| | | | | WO | 2023-016112 | A1 | 16 February 2023 |

Form PCT/ISA/210 (patent family annex) (July 2022)